# EUROPÄISCHE PATENTSCHRIFT

(11) **EP 4 007 924 B1**
(45) Veröffentlichungstag und Bekanntmachung des Hinweises auf die Patenterteilung: **16.08.2023**
(21) Anmeldenummer: 20764030.1
(22) Anmeldetag: 17.08.2020
(51) Int. Cl.: G01R 15/16, G01R 15/06

(54) **MESSANORDNUNG ZUM MESSEN EINES SPANNUNGSPOTENTIALS AN EINEM LEITER IN EINER LEISTUNGSSCHALTVORRICHTUNG UND ENTSPRECHENDE LEISTUNGSSCHALTVORRICHTUNG**
MEASUREMENT ARRANGEMENT FOR MEASURING A VOLTAGE POTENTIAL ON A CONDUCTOR IN A POWER SWITCHING DEVICE AND CORRESPONDING POWER SWITCHING DEVICE
APPAREILLAGE DE MESURE POUR MESURER UN POTENTIEL DE TENSION SUR UN CONDUCTEUR DANS UN DISPOSITIF DE COMMUTATION DE PUISSANCE ET DISPOSITIF DE COMMUTATION DE PUISSANCE CORRESPONDANT

(30) Priorität: 13.09.2019 DE 102019213995
(43) Veröffentlichungstag der Anmeldung: 08.06.2022
(73) Patentinhaber: Siemens Energy Global GmbH & Co. KG, 81739 München (DE)
(72) Erfinder: HILKER, Thomas, 14532 Stahnsdorf (DE)
(86) Internationale Anmeldenummer: PCT/EP2020/072956
(87) Internationale Veröffentlichungsnummer: WO 2021/047858

(56) Entgegenhaltungen:
- WO-A1-2010/070693
- DE-A1- 19 855 528

## Beschreibung

Die Erfindung betrifft eine Spannungspotential-Messanordnung zum Messen eines Spannungspotentials an einem Leiter im Inneren einer gekapselten Leistungsschaltvorrichtung, bei der zumindest ein Abschnitt des Leiters von einem im wesentlichen Feldsteuer-Bauteil, insbesondere einer Feldsteuerelektrode umgeben ist, mit einer Messelektrode zur kapazitiven Ankopplung an den Leiter.

Die Erfindung betrifft weiterhin eine entsprechende gekapselten Leistungsschaltvorrichtung.

Leistungsschaltvorrichtungen (Leistungsschalter) schließen oder öffnen Strompfade hoher elektrischer Spannungen und Ströme. Strom und Spannung werden durch Strom- bzw. Spannungswandler gemessen. Die Messung eines Spannungspotentials an einem Leiter (Primärleiter) findet über eine kapazitive Kopplung zwischen diesem Leiter und der Messelektrode statt. Dazu muss die Messelektrode in unmittelbarer Nähe zu diesem Leiter angeordnet werden. Elektrisch leitfähige Gehäusebauteile der Kapselung schirmen das elektrische Feld des Leiters ab. Auch feldsteuernde Bauteile, wie die Steuerelektrode einer Hochspannungsdurchführung eines Dead Tank Schaltgerätes, wirken abschirmend. Somit kann die Messelektrode auch nicht an solchen Anbauorten montiert werden, die beispielsweise für Stromwandler verwendet werden. Daher wird die Messelektrode in vielen Fällen in das isoliergasgefüllte Schaltergehäuse eingebaut und befindet sich somit in unmittelbarer Nähe zum Leiter. Somit kann das elektrische Feld des Leiters unbeeinflusst auf die Messelektrode wirken.

Die Druckschrift DE 198 30 067 C1 zeigt eine Spannungspotential-Messanordnung zum Messen eines Spannungspotentials an einem als Strombahn bezeichneten Leiter im Inneren einer als Druckgasleistungsschalter ausgebildeten gekapselten Leistungsschaltvorrichtung, bei der zumindest ein Abschnitt des Leiters von einer Außenkontur in Form einer Abschirmelektrode umgeben ist, mit einer Messelektrode zur kapazitiven Ankopplung an den Leiter.

Bei aktuellen Ausführungsformen einer solchen Leistungsschaltvorrichtung ist das Feldsteuer-Bauteil als im Wesentlichen hülsenförmige Feldsteuerelektrode ausgebildet. Weiterhin sind aus der DE 198 55 528 A1 ein kapazitiver Spannungswandler bekannt und aus der WO 2010/070693 A1 der Aufbau eines Strom- und/oder Spannungssensors bekannt.

Der Erfindung liegt die Aufgabe zugrunde, eine Spannungspotential-Messanordnung zum Messen eines Spannungspotentials an einem Leiter im Inneren einer gekapselten Leistungsschaltvorrichtung sowie eine entsprechende gekapselte Leistungsschaltvorrichtung anzugeben, die neue Einbaumöglichkeiten für die Messelektrode eröffnen, insbesondere solche Einbaumöglichkeiten, bei denen die Messelektrode einfach montierbar ist.

Die Aufgabe wird erfindungsgemäß durch die Merkmale der unabhängigen Ansprüche gelöst.

Vorteilhafte Ausgestaltungen der Erfindung sind Gegenstand der Unteransprüche.

Bei der erfindungsgemäßen Spannungspotential-Messanordnung zum Messen eines Spannungspotentials an einem Leiter im Inneren einer gekapselten Leistungsschaltvorrichtung, bei der zumindest ein Abschnitt des Leiters von einem Feldsteuer-Bauteil umgeben ist, mit einer Messelektrode zur kapazitiven Ankopplung an den Leiter, ist vorgesehen, dass die Messelektrode außerhalb des Feldsteuer-Bauteils angeordnet ist und das Feldsteuer-Bauteil auf Höhe der Messelektrode von mindestens einem Durchbruch durchsetzt ist. Dieser ist eine Art Fenster und bildet eine Passage für Feldlinien zwischen Leiter und Messelektrode. Diese bilden die Elektroden eines Kondensators. Auf diese Weise kann die kapazitive Kopplung zwischen Leiter und Messelektrode trotz der Präsenz des Feldsteuer-Bauteils realisiert werden. Das Feldsteuer-Bauteil ist bevorzugt eine Feldsteuerelektrode, insbesondere eine im Wesentlichen hülsenförmige Feldsteuerelektrode.

Durch diese Maßnahmen ergeben sich neue Einbaumöglichkeiten für die Messelektrode. Auf diese Weise ist es nun möglich, eine Messung des Spannungspotentials auch in der Nähe einer Strommessung des elektrischen Stroms durch den Leiter zu ermöglichen.

Gemäß einer bevorzugten Ausführungsform der Erfindung ist die Messelektrode ringförmig ausgestaltet und das Feldsteuer-Bauteil auf Höhe der Messelektrode von mehreren umfänglich verteilten Durchbrüchen durchsetzt. Eine den Leiter umgebende ringförmige Messelektrode zum Messen eines Spannungspotentials an einem Leiter hat sich bewährt.

Gemäß einer weiteren bevorzugten Ausführungsform der Erfindung ist die Kapselung zumindest auf Höhe der Messelektrode als das Feldsteuer-Bauteil umfänglich umgebender Hochspannungsisolator ausgebildet. Der Hochspannungsisolator ist in der Regel aus einem Keramik- oder GFK-Silikon-Composite-Material.

Leistungsschaltvorrichtungen (kurz: Leistungsschalter) weisen derartige Hochspannungsisolatoren in der Regel bei ihren Hochspannungsdurchführungen auf. Dementsprechend wird bei dieser Messanordnung das Spannungspotential an dem Leiter im Bereich einer Hochspannungsdurchführung der gekapselten Leistungsschaltvorrichtung gemessen. Mit Vorteil wird dort auch ein Strom durch den Leiter gemessen.

Dabei ist die Messelektrode insbesondere auch außerhalb des Hochspannungsisolators angeordnet. Dieser Hochspannungsisolator ist eine Art dielektrisches Fenster und bildet eine Passage für Feldlinien zwischen Leiter und Messelektrode. Außerhalb des Hochspannungsisolators ist die Messelektrode besonders einfach montierbar.

Gemäß noch einer weiteren bevorzugten Ausführungsform der Erfindung schließt sich das Feldsteuer-Bauteil unmittelbar an ein Schaltergehäuse der Leistungsschaltvorrichtung an. Eine solche Anordnung von Schaltergehäuse und Feldsteuer-Bauteil ist bei vielen Leistungsschaltvorrichtungen gegeben.

Mit Vorteil ist vorgesehen, dass mindestens zwei der Komponenten Leiter, Feldsteuer-Bauteil und Messelektrode koaxial ausgerichtet sind. Auch der Hochspannungsisolator ist oft koaxial dazu ausgerichtet. Eine solche Anordnung ergibt sich oft bei Hochspannungsdurchführungen.

Bei der erfindungsgemäßen gekapselte Leistungsschaltvorrichtung mit (i) einer Schaltereinheit, (ii) einem mit der Schaltereinheit elektrisch verbundenen Leiter, (iii) einer Kapselung, (iv) einem Feldsteuer-Bauteil und (v) einer Messelektrode zum Messen eines Spannungspotentials an dem Leiter, ist vorgesehen, dass die Messelektrode außerhalb des Feldsteuer-Bauteils angeordnet ist und das Feldsteuer-Bauteil auf Höhe der Messelektrode von mindestens einem Durchbruch durchsetzt ist.

Mit anderen Worten ist bei dieser Leistungsschaltvorrichtung die vorstehend genannte Spannungspotential-Messanordnung zum Messen eines Spannungspotentials an einem Leiter im Inneren der gekapselten Leistungsschaltvorrichtung realisiert.

Eine Ausgestaltung der erfindungsgemäßen gekapselten Leistungsschaltvorrichtung sieht dabei vor, dass die Messelektrode ringförmig ausgestaltet ist und das Feldsteuer-Bauteil auf Höhe der Messelektrode von mehreren umfänglich verteilten Durchbrüchen durchsetzt ist.

Bei einer weiteren Ausgestaltung der erfindungsgemäßen gekapselte Leistungsschaltvorrichtung ist vorgesehen, dass die Kapselung zumindest auf Höhe der Messelektrode als das Feldsteuer-Bauteil umfänglich umgebender Hochspannungsisolator ausgebildet ist, wobei die Messelektrode bevorzugt auch außerhalb des Hochspannungsisolators angeordnet ist.

Bevorzugt ist dabei vorgesehen, dass sich das Feldsteuer-Bauteil unmittelbar an ein die Schaltereinheit einhausendes Schaltergehäuse der Leistungsschaltvorrichtung anschließt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- Fig. 1: eine sich an ein Schaltergehäuse anschließende Hochspannungsdurchführung einer gekapselten Leistungsschaltvorrichtung gemäß einer Ausführungsform der Erfindung in einer Schnittdarstellung, und
- Fig. 2: eine in dieser Teil Hochspannungsdurchführung angeordnete Feldsteuerelektrode.

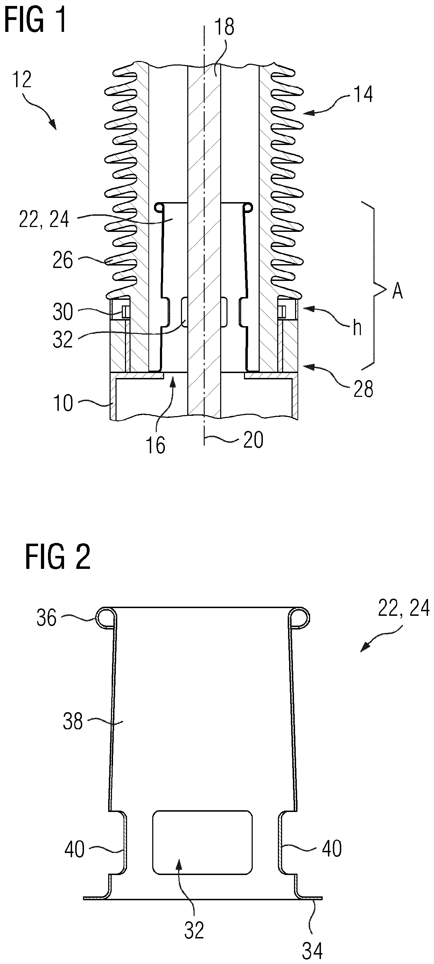

Fig. 1 zeigt einen sich an ein Schaltergehäuse 10 anschließenden Teil einer gekapselten Leistungsschaltvorrichtung 12 in einer Schnittdarstellung. Dieser Teil der gekapselten Leistungsschaltvorrichtung 12 ist eine Hochspannungsdurchführung 14. Der vom Schaltergehäuses 10 gezeigte Teil ist ein im Wesentlichen zylinderförmiger Stutzen und weist an seinem Kopfende einen Durchbruch 16 auf durch den ein Leiter 18 aus dem Schaltergehäuse 10 heraus- und in die Hochspannungsdurchführung 14 hineinführt.

Das Schaltergehäuse 10 haust bei derartigen Leistungsschaltvorrichtungen 12 eine oder mehrere (hier nicht gezeigte) Schalteinheiten ein. Der gezeigte zylinderförmige Stutzen des Schaltergehäuses 10 und der Leiter 18 sind koaxial angeordnet, liegen also auf einer gemeinsamen Achse 20.

An das Kopfende des gezeigten Teils des Schaltergehäuses 10 ist ein als im Wesentlichen hülsenförmige Feldsteuerelektrode 22 ausgebildetes Feldsteuer-Bauteil 24 angeflanscht, welches den Leiter 18 in einem Abschnitt A des Leiters 18 vollumfänglich umgibt. Die hülsenförmige Feldsteuerelektrode 22 ist dann ihrerseits von einem -vorzugsweise keramischen- Hochspannungsisolator 26 vollumfänglich umgeben, der einen Teil der Hochspannungsdurchführung 14 bildet. Auch die Feldsteuerelektrode 22 und der Hochspannungsisolator 26 sind bezüglich der Achse 20 koaxial ausgerichtet. Schaltergehäuse 10 und Hochspannungsisolator 26 sind Teile der Kapselung 28 der gekapselten Leistungsschaltvorrichtung 12.

Auf Höhe h des Abschnitts A umgibt eine ringförmige Messelektrode 30 den Hochspannungsisolator 26. Das als Feldsteuerelektrode 22 ausgebildete Feldsteuer-Bauteil 24 ist auf Höhe der Messelektrode 30 von mehreren umfänglich verteilten Durchbrüchen 32 durchsetzt, die je eine Passage zwischen Leiter 18 und Messelektrode 30 bilden.

Es ergibt sich also im Bereich der Hochspannungsdurchführung 14 eine Spannungspotential-Messanordnung zum Messen eines Spannungspotentials an dem im Inneren der gekapselten Leistungsschaltvorrichtung 12 angeordneten Leiter 18, bei der zumindest der Abschnitt A des Leiters 18 innerhalb der Hochspannungsdurchführung 14 von einer Feldsteuerelektrode 22 umgeben ist. Die Anordnung weist eine Messelektrode 30 zur kapazitiven Ankopplung an den Leiter 18 auf, die außerhalb der Feldsteuerelektrode 22 angeordnet ist, wobei diese Feldsteuerelektrode 22 auf Höhe der Messelektrode 30 von mehreren Durchbrüchen 32 zwischen Leiter 16 und Messelektrode 30 durchsetzt ist. Die Feldsteuerelektrode 22 und der Abschnitt A des Leiters 18 befinden sich dabei im Inneren der der Hochspannungsdurchführung 14, die Messelektrode 30 umgibt auf Höhe h den Außenumfang der Hochspannungsdurchführung 14.

Die gekapselte Leistungsschaltvorrichtung 12 kann als Vakuum-Leistungsschaltvorrichtung 12 ausgebildet sein oder ist -wie hier- eine gasgefüllte Leistungsschaltvorrichtung 12. Diese kann als sogenannter Live-Tank- und Dead-Tank-Leistungsschalter oder als Hybrid- Leistungsschalter ausgestaltet sein.

Die Fig. 2 zeigt die in der (in Fig. 1 gezeigten) Hochspannungsdurchführung 14 angeordnete Feldsteuerelektrode 22 in einer weiteren Schnittdarstellung. Diese Feldsteuerelektrode 22 ist hülsenförmig ausgestaltet und beispielsweise aus Blech gefertigt. An einem Ende der Feldsteuerelektrode 22 befindet sich ein Kragen 34, über den die Feldsteuerelektrode 22 an dem Schaltergehäuse 10 montiert (angeflanscht) werden kann. An dem anderen Ende der Feldsteuerelektrode 22 befindet sich ein ringartig umgebördelter Rand 36, der u.a. die Form der Feldsteuerelektrode 22 an diesem "offenen Ende" stabilisiert. Die Durchbrüche 32 sind deutlich näher an dem Ende mit dem Kragen 34 angeordnet als am offenen Ende (dem anderen Ende mit dem ringartig umgebördelten Rand 36).

Die in der Wand 38 ausgebildeten radial verlaufenden Durchbrüche 32 haben eine einheitliche rechteckige Kontur und sind umfänglich so dicht aufeinander folgend angeordnet, dass zwischen ihnen nur recht schmale Stege 40 verbleiben, deren jeweilige Breite deutlich geringer ist als die Abmessungen der Durchbrüche (Öffnungen) 32. Im gezeigten Beispiel der Fig. 2 haben die Stege 40 eine Breite von weniger als einem Drittel der umfänglichen Ausdehnung der Durchbrüche 32.

Im Folgenden sollen wesentliche Details der Spannungspotential-Messanordnung zum Messen eines Spannungspotentials an dem Leiter 16 im Inneren der gekapselten Leistungsschaltvorrichtung 12 nach einmal mit anderen Worten beschrieben werden.

Die Messelektrode 30 zur Spannungsmessung wird außerhalb des Schaltergehäuses 10 am Fuß des Hochspannungsisolators 26 montiert. Das feldsteuernde Bauteil 24, also die Feldsteuerelektrode 22 der Hochspannungsdurchführung 14, ist mit Öffnungen (Durchbrüche 32) durchsetzt. Die Öffnungen 32 in der Feldsteuerelektrode 22 unterbrechen die abschirmende Wirkung. Das elektrische Feld des Primärleiters 18 kann auf die Messelektrode 30 einwirken. So wird eine kapazitive Kopplung zwischen Primärleiter 18 und Messelektrode 30 erreicht und eine Messung der Primärspannung auch in der Nähe einer Strommessung ermöglicht.

### Bezugszeichenliste:

- 10: Schaltergehäuse
- 12: Leistungsschaltvorrichtung
- 14: Hochspannungsdurchführung
- 16: Durchbruch
- 18: Leiter
- 20: Achse
- 22: Feldsteuerelektrode
- 24: Feldsteuer-Bauteil
- 26: Hochspannungsisolator
- 28: Kapselung
- 30: Messelektrode
- 32: Durchbruch
- 34: Kragen
- 36: umgebördelter Rand
- 38: Wand
- 40: Steg
- A: Abschnitt
- H: Höhe

## Patentansprüche

1. Spannungspotential-Messanordnung zum Messen eines Spannungspotentials an einem Leiter (18) im Inneren einer gekapselten Leistungsschaltvorrichtung (12), bei der zumindest ein Abschnitt (A) des Leiters (18) von einem Feldsteuer-Bauteil (24), insbesondere einer Feldsteuerelektrode (22) umgeben ist, mit einer Messelektrode (30) zur kapazitiven Ankopplung an den Leiter (18),
**dadurch gekennzeichnet, dass** die Messelektrode (30) außerhalb des Feldsteuer-Bauteils (24) angeordnet ist und das Feldsteuer-Bauteil (24) auf Höhe der Messelektrode (30) von mindestens einem Durchbruch (32) durchsetzt ist.

2. Spannungspotential-Messanordnung nach Anspruch 1, **dadurch gekennzeichnet, dass** die Messelektrode (30) ringförmig ausgestaltet ist und das Feldsteuer-Bauteil (24) auf Höhe der Messelektrode (30) von mehreren umfänglich verteilten Durchbrüchen (32) durchsetzt ist.

3. Spannungspotential-Messanordnung nach Anspruch 1 oder 2, **dadurch gekennzeichnet, dass** die Kapselung (28) zumindest auf Höhe der Messelektrode (30) als das Feldsteuer-Bauteil (24) umfänglich umgebender Hochspannungsisolator (26) ausgebildet ist.

4. Spannungspotential-Messanordnung nach Anspruch 3, **dadurch gekennzeichnet, dass** die Messelektrode (30) auch außerhalb des Hochspannungsisolators (26) angeordnet ist.

5. Spannungspotential-Messanordnung nach einem der Ansprüche 1 bis 4,
**dadurch gekennzeichnet, dass** sich das Feldsteuer-Bauteil (24) unmittelbar an ein Schaltergehäuse (10) der Leistungsschaltvorrichtung (12) anschließt.

6. Spannungspotential-Messanordnung nach einem der Ansprüche 1 bis 5,
**dadurch gekennzeichnet, dass** mindestens zwei der Komponenten Leiter (18), Feldsteuer-Bauteil (24) und Messelektrode (30) koaxial ausgerichtet sind.

7. Gekapselte Leistungsschaltvorrichtung mit
- einer Schaltereinheit,
- einem mit der Schaltereinheit elektrisch verbundenen Leiter (18),
- einer Kapselung (28),
- einem Feldsteuer-Bauteil (24) und
- einer Messelektrode (30) zum Messen eines Spannungspotentials an dem Leiter (18),
**dadurch gekennzeichnet, dass**
die Messelektrode (30) außerhalb des Feldsteuer-Bauteils (24) angeordnet ist und das Feldsteuer-Bauteil (24) auf Höhe der Messelektrode (30) von mindestens einem Durchbruch (32) durchsetzt ist.

8. Leistungsschaltvorrichtung nach Anspruch 7,
**dadurch gekennzeichnet, dass** die Messelektrode (30) ringförmig ausgestaltet ist und das Feldsteuer-Bauteil (24) auf Höhe der Messelektrode (30) von mehreren umfänglich verteilten Durchbrüchen (32) durchsetzt ist.

9. Leistungsschaltvorrichtung nach Anspruch 7 oder 8,
**dadurch gekennzeichnet, dass** die Kapselung (28) zumindest auf Höhe der Messelektrode (30) als das Feldsteuer-Bauteil (24) umfänglich umgebender Hochspannungsisolator (26) ausgebildet ist, wobei die Messelektrode (30) bevorzugt auch außerhalb des Hochspannungsisolators (30) angeordnet ist.

10. Leistungsschaltvorrichtung nach Anspruch 9,
**dadurch gekennzeichnet, dass** sich das Feldsteuer-Bauteil (24) unmittelbar an ein die Schaltereinheit einhausendes Schaltergehäuse (10) der Leistungsschaltvorrichtung (12) anschließt.

## Claims

1. Voltage potential measurement arrangement for measuring a voltage potential at a conductor (18) in the interior of an encapsulated power switching device (12), in which at least one portion (A) of the conductor (18) is surrounded by a field control component (24), in particular a field control electrode (22), having a measurement electrode (30) for capacitive coupling to the conductor (18),
**characterized in that** the measurement electrode (30) is arranged outside of the field control component (24) and at least one aperture (32) passes through the field control component (24) at the height of the measurement electrode (30).

2. Voltage potential measurement arrangement according to Claim 1,
**characterized in that** the measurement electrode (30) is of annular configuration and a plurality of circumferentially distributed apertures (32) pass through the field control component (24) at the height of the measurement electrode (30).

3. Voltage potential measurement arrangement according to Claim 1 or 2,
**characterized in that** the encapsulation (28) is in the form of a high-voltage insulator (26) circumferentially surrounding the field control component (24) at least at the height of the measurement electrode (30).

4. Voltage potential measurement arrangement according to Claim 3,
**characterized in that** the measurement electrode (30) is also arranged outside of the high-voltage insulator (26).

5. Voltage potential measurement arrangement according to one of Claims 1 to 4,
**characterized in that** the field control component (24) directly adjoins a switch housing (10) of the power switching device (12) .

6. Voltage potential measurement arrangement according to one of Claims 1 to 5,
**characterized in that** at least two of the components out of the conductor (18), field control component (24) and measurement electrode (30) are oriented coaxially.

7. Encapsulated power switching device, having
- a switch unit,
- a conductor (18) electrically connected to the switch unit,
- an encapsulation (28),
- a field control component (24), and
- a measurement electrode (30) for measuring a voltage potential at the conductor (18),
**characterized in that**
the measurement electrode (30) is arranged outside of the field control component (24) and at least one aperture (32) passes through the field control component (24) at the height of the measurement electrode (30).

8. Power switching device according to Claim 7, **characterized in that** the measurement electrode (30) is of annular configuration and a plurality of circumferentially distributed apertures (32) pass through the field control component (24) at the height of the measurement electrode (30).

9. Power switching device according to Claim 7 or 8, **characterized in that** the encapsulation (28) is in the form of a high-voltage insulator (26) circumferentially surrounding the field control component (24) at least at the height of the measurement electrode (30), wherein the measurement electrode (30) is preferably also arranged outside of the high-voltage insulator (30).

10. Power switching device according to Claim 9,
**characterized in that** the field control component (24) directly adjoins a switch housing (10), which houses the switch unit, of the power switching device (12).

## Revendications

1. Appareillage de mesure d'un potentiel de tension pour la mesure d'un potentiel de tension sur un conducteur (18) à l'intérieur d'un système (12) de coupure de puissance blindé, dans lequel au moins un tronçon (A) du conducteur (18) est entouré d'une pièce (24) de commande de champ, en particulier d'une électrode (22) de commande de champ, comprenant une électrode (30) de mesure pour le couplage capacitif avec le conducteur (18),
**caractérisé en ce que** l'électrode (30) de mesure est disposée à l'extérieur de la pièce (24) de commande de champ et la pièce (24) de commande de champ est, au niveau de l'électrode (30) de mesure, traversée par au moins une traversée (32).

2. Appareillage de mesure d'un potentiel de tension suivant la revendication 1,
**caractérisé en ce que** l'électrode (30) de mesure est conformée annulairement et la pièce (24) de commande de champ est traversée, au niveau de l'électrode (30) de mesure, par plusieurs traversées (32) réparties sur le pourtour.

3. Appareillage de mesure d'un potentiel de tension suivant la revendication 1 ou 2,
**caractérisé en ce que** le blindage (28) est constitué, au moins au niveau de l'électrode (30) de mesure, en isolateur (26) de haute tension entourant sur le pourtour la pièce (24) de commande de champ.

4. Appareillage de mesure d'un potentiel de tension suivant la revendication 3,
**caractérisé en ce que** l'électrode (30) de mesure est disposée également à l'extérieur de l'isolateur (26) de haute tension.

5. Appareillage de mesure d'un potentiel de tension suivant l'une des revendications 1 à 4,
**caractérisé en ce que** la pièce (24) de commande de champ se raccorde directement à un boîtier (10) d'interrupteur du système (12) de coupure de puissance.

6. Appareillage de mesure d'un potentiel de tension suivant l'une des revendications 1 à 5,
**caractérisé en ce qu'**
au moins deux des composants, conducteur (18), pièce (24) de commande de champ et électrode (30) de mesure sont dirigés coaxialement.

7. Système de coupure de puissance blindé comprenant :
- une unité de coupure,
- un conducteur (18) relié électriquement à l'unité de coupure,
- un blindage (28),
- une pièce (24) de commande de champ, et
- une électrode (30) de mesure pour la mesure d'un potentiel de tension sur le conducteur (18),
**caractérisé en ce que**
l'électrode (30) de mesure est disposée à l'extérieur de la pièce (24) de commande de champ et la pièce (24) de commande de champ est traversée, au niveau de l'électrode (30) de mesure, par au moins une traversée (32).

8. Système de coupure de puissance suivant la revendication 7, **caractérisé en ce que** l'électrode (30) de mesure est conformée annulairement et la pièce (24) de commande de champ est traversée, au niveau de l'électrode (30) de mesure, par plusieurs traversées (32) réparties sur le pourtour.

9. Système de coupure de puissance suivant la revendication 7 ou 8,
**caractérisé en ce que** le blindage (28) est constitué, au moins au niveau de l'électrode (30) de mesure, en isolateur (26) de haute tension entourant sur le pourtour la pièce (24) de commande de champ, l'électrode (30) de mesure étant, de préférence, également disposée à l'extérieur de l'isolateur (30) de haute tension.

10. Système de coupure de puissance suivant la revendication 9, **caractérisé en ce que** la pièce (24) de commande de champ se raccorde directement à un boîtier (10) d'interrupteur, logeant l'unité d'interrupteur, du système (12) de coupure de puissance.
